# EUROPÄISCHE PATENTSCHRIFT

(11) **EP 1 969 156 B1**
(45) Veröffentlichungstag und Bekanntmachung des Hinweises auf die Patenterteilung: **05.09.2012**
(21) Anmeldenummer: 06849387.3
(22) Anmeldetag: 12.12.2006
(51) Int. Cl.: C23C 28/00, C23C 30/00, C23C 16/06, C23C 4/06

(54) **VERFAHREN ZUM BESCHICHTEN EINER SCHAUFEL UND SCHAUFEL EINER GASTURBINE**
METHOD FOR COATING A BLADE AND BLADE OF A GAS TURBINE
PROCEDE DE REVETEMENT D'UNE AUBE ET AUBE D'UNE TURBINE A GAZ

(30) Priorität: 14.12.2005 DE 102005060243
(43) Veröffentlichungstag der Anmeldung: 17.09.2008
(73) Patentinhaber: MAN Diesel & Turbo SE, 86153 Augsburg (DE)
(72) Erfinder: CHANDRA, Sharad, 56077 Koblenz (DE); CZECH, Norbert, 46286 Dorsten (DE)
(86) Internationale Anmeldenummer: PCT/EP2006/011943
(87) Internationale Veröffentlichungsnummer: WO 2007/101465

(56) Entgegenhaltungen:
- EP-A- 0 846 788
- EP-A- 1 637 622
- EP-A2- 0 949 410
- WO-A-00/17417
- WO-A-97/05299
- WO-A-2005/106064
- WO-A-2006/061431

## Beschreibung

Die Erfindung betrifft ein Verfahren zum Beschichten einer hohlen, gekühlten Schaufel einer Gasturbine mit den Merkmalen des Oberbegriffes des Anspruches 1 sowie eine solche Schaufel einer Gasturbine.

Die Oberflächen im Heißgasbereich werden in modernen Gasturbinen zum Schutz vor Hochtemperaturoxidation und Hochtemperaturkorrosion fast vollständig mit Beschichtungen versehen. Ausnahmen bilden in manchen Fällen noch die Schaufeln der hinteren Turbinenreihen. Durchgesetzt haben sich chrom- und aluminiumoxidbildende Diffusions- und Auflageschichten. Bei letzteren haben MCrAlY-Auflageschichten (M = Ni, Co) die weiteste Verbreitung in stationären Gasturbinen gefunden.

Parallel hierzu wurden zunehmend gekühlte, das heißt hohle Schaufeln konstruiert, um die Materialtemperatur auf einem für die zur Verfügung stehenden Werkstoffe erträglichen Niveau zur halten. Die Kühlung erfolgt mit komprimierter Luft, die - abhängig vom Umgebungsdruck der zu kühlenden Schaufel - bestimmten Stufen des Verdichters der Gasturbinenanlage entnommen wird. Die Temperatur der Kühlluft liegt zwischen etwa 450 °C am Eintritt in die Schaufel und etwa 800 °C am Austritt aus der Schaufel. Bei hochbeanspruchten gekühlten Schaufeln werden zunehmend Innenbeschichtungen eingesetzt, welche oxidationsbedingte Korngrenzenangriffe verhindern, die risseinleitend wirken können. Durch die Verwendung von Innenbeschichtungen bei Schaufeln kann die Thermomechanische Ermüdungslebensdauer (Thermo Mechanical Fatique - TMF) deutlich verbessert werden.

Aus prozesstechnischen Gründen werden bisher fast ausschließlich durch Alitierung erzeugte Al-Diffusionsschichten eingesetzt. Der Nachteil einer Al-Diffusionsschicht als Innenbeschichtung liegt in der Sprödigkeit der Al-Diffusionsschicht und deren verhältnismäßig geringe Beständigkeit gegen Erreger von Hochtemperaturkorrosion, die als Kontaminierung in der Kühlluft vorhanden sein können. Daneben ist auch auf durch Chromieren erzeugte Cr-Diffusionsschichten zum Schutz gegen Höchtemperaturoxidation und -korrosion hingewiesen worden.

Auf gekühlten Bauteilen, wie Schaufeln von Gasturbinen, kommen Wärmedämmschichtsysteme zum Einsatz. Die Wärmedämmschichten bestehen immer aus einer mit dem Grundwerkstoff durch Diffusion verbundenen metallischen Haftschicht und einer darüber liegenden Keramikschicht mit schlechter Wärmeleitfähigkeit, die die eigentliche Barriere gegen den Wärmestrom darstellt.

Als Haftschichten können prinzipiell sowohl Diffusions- als auch Auflageschichten vom MCrAlY-Typ eingesetzt werden. Die wichtigste Eigenschaft der Haftschichten ist die Fähigkeit, ein möglichst reines Aluminiumoxid auf ihrer Oberfläche zu bilden, wodurch die zyklische und statische Bindung des Wärmedämmschichtsystems gewährleistet wird.

MCrAlY-Schichten enthalten in einer NiCoCr("γ")-Matrix die intermetallische ß-Phase NiCoAl als Aluminium-Vorrat. Die β-Phase NiCoAl hat allerdings auch einen versprödenden Einfluss, so dass der praktisch realisierbare Al-Gehalt bei ≤ 12 Gew.-% liegt. Zur weiteren Steigerung der Oxidationsbeständigkeit ist es möglich, die MCrAlY-Schichten durch Alitieren mit einer Al-Diffusionsschicht zu überziehen. Wegen der Versprödungsgefahr beschränkt man dies weitgehend auf aluminiumarme Ausgangsschichten.

Um den Al-Gehalt in der McrAlY-Schicht zu erhöhen, wird in der deutschen Patentanmeldung 10 2004 045 049.8 vorgeschlagen, die Alitierung so weit fortzusetzen, dass eine Al-Diffusionsschicht mit einem Al-Gehalt von etwa 20% und darüber eine Al-Aufbauschicht von etwa 30% erzeugt werden (Überalitierung). Die Al-Aufbauschicht enthält die sehr spröde ß-NiAl-Phase. Durch eine abrasive Behandlung, z. B. durch Strahlen mit harten Partikeln wird die äußere Al-Aufbauschicht bis herab zur Al-Diffusionsschicht entfernt, wodurch der Al-Gehalt in der verbleibenden Diffusionsschicht mindestens 18% und maximal 30% beträgt.

Der Erfindung liegt die Aufgabe zugrunde, das gattungsgemäße Beschichtungsverfahren so zu verbessern, dass die Neigung der Innenbeschichtung zur Rissbildung durch Thermomechanische Ermüdung vermindert und das Aufbringen der Außenbeschichtung erleichtert wird.

Die Aufgabe wird bei einem gattungsgemäßen Verfahren erfindungsgemäß durch die kennzeichnenden Merkmale des Anspruches 1 gelöst. Vorteilhafte Ausgestaltungen der Erfindung sind in den Unteransprüchen angegeben. Eine nach dem Verfahren hergestellte Schaufel ist Gegenstand des Anspruches 4.

Durch den Ersatz der tendenziell spröden Alitierung als Innenbeschichtung durch eine Chromierung wird aufgrund der duktileren Cr-Diffusionsschicht eine verminderte Neigung zur Risseinleitung und damit eine Verbesserung der sogenannten Thermomechanischen Ermüdungslebensdauer der thermisch hochbeanspruchten Schaufeln erreicht. Neben den verbesserten mechanischen Eigenschaften wird auch eine deutlich gesteigerte Beständigkeit gegen Hochtemperaturkorrosion erzielt, die im Falle schwefelkontaminierter Kühlluft im Betriebstemperaturbereich der Innenbeschichtung von Bedeutung ist. Ein prozesstechnischer vorteil besteht ferner darin, dass das Überalitieren der MCrAlY-Außenbeschichtung durch die im Innenbeschichtungsprozess erzielte oberflächliche Chromanreicherung erleichtert wird und die Dauer des Alitierungprozesses verkürzt werden kann.

Ein Ausführungsbeispiel der Erfindung wird im Folgenden an Hand der Zeichnung näher erläutert.

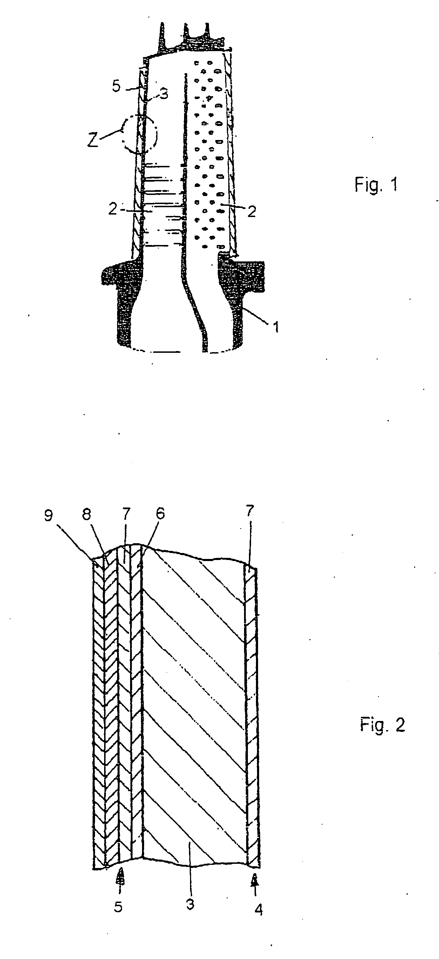

Es zeigen
Fig. 1 den Längsschnitt durch eine Gasturbinenschaufel und
Fig. 2 die Einzelheit Z nach Fig. 1 in nicht maßstabsgerechter Darstellung

Die Schaufel 1 einer Gasturbine ist hohl und weist im Inneren Kühlkanäle 2 auf. Die Kühlkanäle 2 sind von komprimierter Luft durchströmt, die an geeigneten Stufen des Verdichters der Gasturbinenanlage entnommen wird.

Die Wand der Schaufel 1 besteht aus einem Grundwerkstoff 3 aus einer hochwarmfesten Legierung auf Nickel- oder Kobaltbasis. Der Grundwerkstoff 3 ist auf der inneren, den Kühlkanälen 2 zugewandten Seite mit einer Innenbeschichtung 4 und auf der Außenseite mit einer Außenbeschichtung 5 versehen, deren Herstellung nachfolgend beschrieben wird.

Ausgangszustand für die Herstellung der Beschichtung ist die fertig bearbeitete Schaufel 1. In einem ersten Schritt wird auf die Außenseite der Schaufel 1 als untere Schicht der Außenbeschichtung 5 eine Haftschicht 6 aus einer MCrAlY-Legierung aufgebracht. Das Aufbringen erfolgt nach dem Niederdruck-Plasma-Spritzverfahren (Low Pressure Plasma Spraying - LPPS) oder mit Hilfe des Hochgeschwindigkeitsflammspritzens (High Valued Oxygen Flamming - HVOF). Auf diese Weise wird eine sehr dichte und qualitativ hochwertige Schicht erzeugt.

Im zweiten Schritt wird die gesamte Schaufel 1 einer Chromierung nach dem chemischen Dampfabscheide-Prozess (Chemical Vapour Deposition - CVD) unterworfen. Bei diesem Verfahren wird mit der Schaufel 1 ein heißes, reaktives, Cr-haltiges Gas in Kontakt gebracht, das bei höherer Temperatur auf dem Grundwerkstoff 3 und der Haftschicht 6 aus MCrAlY eine Einwärtsdiffusion von Cr, verbunden mit einer Auswärtsdiffusion von Ni, bewirkt. Es entsteht in diesem Schritt gleichzeitig eine Cr-Diffusionsschicht 7 als Innenbeschichtung 4 und als Zwischenschicht auf der Haftschicht 6 der Außenbeschichtung 5.

Im dritten Schritt wird die mit der Cr-Diffusionsschicht 7 überzogene Haftschicht 6 einer Überalitierung nach dem chemischen Dampfabscheide-Prozess unterworfen, indem die Haftschicht 6 einem heißen, reaktiven, Al-haltigen Gas ausgesetzt wird. Bei dieser Variante der Alitierung wird - wie in der eingangs genannten deutschen Patentanmeldung 10-2004 045 049.8 beschrieben - zusätzlich auf einer eigentlichen Al-Diffusionsschicht 8 eine Al-Aufbauschicht erzeugt, welche die sehr spröde ß-NiAl-Phase enthält.

Vorzugsweise erfolgt als vierter Schritt eine Wärmebehandlung der Schaufel 1, um durch ein Lösungsglühen mit anschließender Aushärtung optimale Werkstoffeigenschaften des Grundwerkstoffs 3 zu erreichen.

Im fünften Schritt wird - wie in der eingangs genannten deutschen Patentanmeldung 10 2004 045 049.8 beschrieben - die sehr spröde ß-NiAl-Phase durch eine abrasive Behandlung entfernt, z. B. durch Strahlen mit harten Partikeln, so dass nur die eigentliche Al-Diffusionsschicht 8 bestehen bleibt.

Im sechsten und letzten Schritt wird auf die chromierte und alitierte MCrAlY-Haftschicht 6 eine Wärmedämmschicht 9 nach dem Elektronenstrahl-Aufdampfprozess (Elekton Beam Physical Vapour Deposition - EB-PVD) aufgebracht. Die Wärmedämmschicht 9 besteht aus Zirkonoxid, das mit etwa 7% Yttriumoxid teilstabilisiert ist.

Abgesehen von dem Verfahren der Überaltierung sind die einzelnen genannten Beschichtungsverfahren in der Beschichtungstechnik allgemein bekannt, so dass auf eine nähere Beschreibung verzichtet werden kann. Für den Erfolg des erfindungsgemäßen Verfahrens ist die Einhaltung der einzelnen Verfahrensschritte entscheidend.

## Patentansprüche

1. Verfahren zur Beschichtung einer hohlen, innen gekühlten Schaufel (1) einer Gasturbine, wobei auf den Grundwerkstoff (3) der Schaufel (1) auf der Außenseite der Schaufel (1) eine Außenbeschichtung (5) aus einer Haftschicht (6) auf MCrAlY-Basis und aus einer keramischen Wärmedämmschicht (9) aus Zirkonoxid und auf der Innenseite der Schaufel (1) eine Innenbeschichtung (4) aus einer Cr-Diffusionsschicht (7) aufgebracht wird,
**dadurch gekennzeichnet,**
**dass** die Haftschicht (6) auf MCrAlY-Basis auf die fertig bearbeitete Schaufel (1) aufgebracht wird,
**dass** durch chemische Dampfabscheidung gleichzeitig mit der Innenbeschichtung (4) die Cr-Diffusionsschicht (7) auch auf die Haftschicht (6) auf MCrAlY-Basis der Außenbeschichtung (5) aufgebracht wird,
**dass** auf die mit der Cr-Diffusionsschicht (7) überzogene Haftschicht (6) eine Al-Diffusionsschicht (8) und eine äußere spröde Al-Aufbauschicht durch chemische Dampfabscheidung aufgebracht wird,
**dass** die äußere spröde Al-Aufbauschicht durch eine abrasive Behandlung entfernt wird
und **dass** danach auf die Al-Diffusionsschicht (8) die keramische Wärmedämmschicht (9) aufgebracht wird.

2. Verfahren nach Anspruch 1, **dadurch gekennzeichnet, dass** vor der abrasiven Behandlung der spröden Al-Aufbauschicht die Schaufel (1) einer Wärmebehandlung durch Lösungsglühen unterworfen wird.

3. Verfahren nach Anspruch 1 oder 2, **dadurch gekennzeichnet, dass** die Haftschicht (6) als Auflageschicht durch Plasma- oder Hochgeschwindigkeitsspritzen aufgebracht wird.

4. Hohle, gekühlte Schaufel einer Gasturbine, bei der auf den Grundwerkstoff (3) der Schaufel (1) auf der Außenseite der Schaufel (1) eine Außenbeschichtung (5) aus einer Haftschicht (6) auf MCrAlY-Basis und aus einer keramischen Wärmedämmschicht (9) aus Zirkonoxid und auf der Innenseite der Schaufel (1) eine Innenbeschichtung (4) aus einer CrDiffusionsschicht (7) aufgebracht ist, **dadurch gekennzeichnet, dass** auf der Haftschicht (6) auf MCrAlY-Basis der Außenbeschichtung (5) eine Cr-Diffusionsschicht (7) und darauf eine Al-Diffusionsschicht (8) und die keramische Wärmedämmschicht (9) aufgebracht sind.

## Claims

1. A method for coating a hollow, internally cooled blade (1) of a gas turbine, wherein an external coating (5) of an adhesion layer (6) on MCrAlY-base and of a ceramic heat-insulating layer (9) of zirconium oxide is applied onto the base material (3) of the blade (1) on the outside of the blade (1) and an internal coating (4) of a Cr-diffusion layer (7) is applied onto the inside of the blade (1),
**characterized in that** the adhesion layer (6) on MCrAlY-basis is applied onto the finish-processed blade (1),
**in that** through chemical vapour deposition simultaneously with the internal coating (4) the Cr-diffusion layer (7) is also applied onto the adhesion layer (6) on MCrAlY-basis of the outer coating (5),
**in that** the adhesion layer (6) with which the Cr-diffusion layer (7) is covered an Al-diffusion layer (8) and an external, brittle Al-build-up layer is applied through chemical vapour deposition,
**in that** the external brittle Al-build-up layer is removed through an abrasive treatment and **in that** thereafter the ceramic heat insulation layer (9) is applied onto the Al-diffusion layer (8).

2. The method according to Claim 1, **characterized in that** prior to the abrasive treatment of the brittle Al-build-up layer the blade (1) is subjected to heat treatment through solution-annealing.

3. The method according to Claim 1 or 2, **characterized in that** the adhesion layer (6) is applied as support layer through plasma or highspeed spraying.

4. A hollow, cooled blade of a gas turbine, wherein onto the base material (3) of the blade (1) on the outside of the blade (1) an external coating (5) of an adhesion layer (6) on MCrAlY-basis and of a ceramic heat insulation layer (9) of zirconium oxide is applied and on the inside of the blade (1) an internal coating (4) of a Cr-diffusion layer (7) is applied, **characterized in that** on the adhesion layer (6) on MCrAlY-basis of the outer coating (5) a Cr-diffusion layer (7) and thereupon an Al-diffusion layer (8) and the ceramic heat insulation layer (9) are applied.

## Revendications

1. Procédé de revêtement d'une pale creuse (1) à refroidissement interne (1) d'une turbine à gaz, dans lequel, sur le matériau de base (3) de la pale (1), sur la face extérieure de la pale (1), un revêtement extérieur (5) fait d'une couche adhérente (6) à base de McrAlY et d'une couche d'isolation thermique céramique (9) en oxyde de zirconium et sur la face extérieure de la pale (1), un revêtement intérieur (4) fait d'une couche de diffusion en Cr (7) est appliqué,
**caractérisé en ce que**
la couche adhérente (6) à base de MCrAlY est appliquée sur la pale finie (1),
que, par déposition chimique de vapeur, en même temps que le revêtement intérieur (4), la couche de diffusion en Cr (7) du revêtement extérieur (5) est aussi appliquée sur la couche adhérente (6) à base de MCrAlY du revêtement extérieur (5),
que, sur la couche adhérente (6) enrobée de la couche de diffusion en Cr (7), une couche de diffusion en Al (8) et une couche structurelle friable extérieure en Al est appliquée par déposition chimique de vapeur,
que la couche structurelle friable extérieure en Al est enlevée par traitement abrasif
et qu'ensuite la couche d'isolation thermique céramique (9) est appliquée sur la couche de diffusion en Al (8).

2. Procédé selon la revendication 1, **caractérisé en ce que**, avant le traitement abrasif de la couche structurelle friable en Al, la pale (1) est soumise à un traitement thermique par recuit de mise en solution.

3. Procédé selon la revendication 1 ou 2, **caractérisé en ce que** la couche adhérente (6) est appliquée sous forme de couche d'application par injection au plasma ou à grande vitesse.

4. Pale creuse refroidie d'une turbine à gaz, dans laquelle, sur le matériau de base (3) de la pale (1), sur la face extérieure de la pale (1), un revêtement extérieur (5) fait d'une couche adhérente (6) à base de McrAlY et d'une couche d'isolation thermique céramique (9) en oxyde de zirconium et sur la face intérieure de la pale (1), un revêtement intérieur (4) fait d'une couche de diffusion en Cr (7) est appliqué,
**caractérisé en ce que**
sur la couche adhérente (6) à base de MCrAlY du revêtement extérieur (5), est appliquée une couche de diffusion en Cr (7) puis par-dessus une couche de diffusion en Al (8) et la couche d'isolation thermique céramique (9).
